# EUROPEAN PATENT APPLICATION

(11) **EP 3 139 397 A1**
(43) Date of publication of application: **08.03.2017**
(21) Application number: 16186479.8
(22) Date of filing: 31.08.2016
(51) Int. Cl.: H01J 37/18

(54) **TRANSPORT DEVICE, TREATMENT DEVICE, VACUUM DEVICE, AND CHARGED PARTICLE BEAM DEVICE**

(30) Priority: 02.09.2015 JP 2015173237
(71) Applicant: Hitachi High-Tech Science Corporation, Tokyo (JP)
(72) Inventor: IWAHORI, Toshiyuki, Tokyo (JP); HASUDA, Masakatsu, Tokyo (JP)
(74) Representative: Zacco GmbH

(57) **Abstract**

Provided is a transport device in which a reduction in the size and a reduction in the cost of the entire device are possible. A transport unit 20 which is interposed between a sub-chamber 4 and a first treatment chamber 10 is provided with: a transport bar 21 which transports a sample S along a right-left direction in a preliminary sample chamber; a support 31 which supports the transport bar; a case 41 which supports the support so as to be rotatable around a rotation axis intersecting the right-left direction; and a second O-ring 52 which seals an inside of the case. The preliminary sample chamber and a first treatment space can communicate with each other through the inside of the case. The transport bar is made so as to be able to transition between a first state where the transport bar can transport the sample between the preliminary sample chamber and the inside of the case, and a second state where the transport bar can transport the sample between the first treatment space and the inside of the case, by rotation of the support with respect to the case.

## Description

### BACKGROUND OF THE INVENTION

### Field of the Invention

The present invention relates to a transport device, a treatment device, a vacuum device, and a charged particle beam device.

### Description of Related Art

In the related art, for example, in analysis of a biological sample or the like, there is a case where after treatment such as cooling is performed on the sample, the sample is analyzed in an analysis device. In this case, there is a case where after treatment of the sample is performed in a device for a treatment process provided independently of the analysis device, the sample is transported to the analysis device by using a case or the like which can transfer the sample in a state where it is isolated from the atmosphere. In this way, the sample is prevented from coming into direct contact with oxygen, water, or the like in the air.

For example, Patent Document 1 discloses a configuration of transporting a sample from an external cryo-station into an electron microscope by using a sample holder for preventing frost from adhering to the sample.

### Prior Art Document

### Patent Document

Patent Document 1
Published Japanese Translation No. 2004-508661 of the PCT International Publication

### SUMMARY OF THE INVENTION

However, in the configuration of the related art described above, the analysis device and the device for a treatment process are independently provided, and therefore, there is a problem in which the size of an entire device increases and a cost increases.

Therefore, the present invention is for providing a transport device, a treatment device, a vacuum device, and a charged particle beam device, in which a reduction in the size and a reduction in the cost of the entire device are possible.

In order to solve the above problem, according to an aspect of the present invention, there is provided a transport device which is interposed between a first chamber and a second chamber, including: a transport bar which transports a sample along a predetermined direction in the first chamber; a support which supports the transport bar; a case which supports the support so as to be rotatable around a rotation axis intersecting the predetermined direction; and a seal member which is disposed between the support and the case and seals the inside of the case, in which the inside of the first chamber and the inside of the second chamber can communicate with each other through the inside of the case, and the transport bar is made so as to be able to transition between a first state where the transport bar can transport the sample between the inside of the first chamber and the inside of the case, and a second state where the transport bar can transport the sample between the inside of the second chamber and the inside of the case, by rotation of the support with respect to the case.

According to the present invention, the inside of the case is sealed by the seal member and the transport bar is made so as to be able to transition between the first state where the transport bar can transport the sample between the inside of the first chamber and the inside of the case, and the second state where the transport bar can transport the sample between the inside of the second chamber and the inside of the case. Therefore, it is possible to mutually transfer the sample between the first chamber and the second chamber under an isolated atmosphere. For this reason, it becomes possible to connect the first chamber and the second chamber in a state where the inside of the first chamber and the inside of the second chamber communicate with each other under an isolated atmosphere. Therefore, it is possible to provide a transport device in which a reduction in the size and a reduction in the cost of the entire device are possible, compared to a configuration in which a first chamber and a second chamber with an isolated internal atmosphere are disposed independently of each other.

According to another aspect of the present invention, there is provided a treatment device including: the above-described transport device; the first chamber; and the second chamber.

According to the present invention, it is possible to transfer the sample subjected to treatment such as cooling in, for example, the second chamber, to the first chamber by the transport bar of the transport device. Therefore, a reduction in the size and a reduction in the cost of a treatment device are possible, compared to a treatment device of the related art in which a device for a treatment process and an analysis device are independently provided.

In the treatment device described above, it is preferable that the treatment device further includes a first gate valve which is interposed between the first chamber and the case and opens and closes a communication passage between the inside of the first chamber and the inside of the case.

According to the present invention, the communication between the inside of the first chamber and the inside of the second chamber can be cut off by blocking the communication passage between the inside of the first chamber and the inside of the case by the first gate valve. In this way, in a case where the second chamber can become a contamination source with respect to the first chamber, a case where gas is generated from the second chamber, or the like, a contaminant, gas, or the like can be prevented from flowing from the second chamber into the first chamber.

In the treatment device described above, it is preferable that the transport device is detachably connected to the first gate valve.

According to the present invention, a transport unit along with the second chamber can be mounted and dismounted with respect to the first chamber in a state where the atmosphere of the inside of the first chamber is cut off by blocking the communication passage between the inside of the first chamber and the inside of the case by the first gate valve. In this way, the atmosphere of the inside of the first chamber can be maintained as a desired atmosphere, and therefore, it is possible to efficiently perform analysis and treatment of the sample.

In the treatment device described above, it is preferable that the treatment device further includes a second gate valve which is interposed between the second chamber and the case and opens and closes a communication passage between the inside of the second chamber and the inside of the case.

According to the present invention, the communication between the inside of the first chamber and the inside of the second chamber can be cut off by blocking the communication passage between the inside of the second chamber and the inside of the case by the second gate valve. In this way, in a case where the second chamber can become a contamination source with respect to the first chamber, a case where gas is generated from the second chamber, or the like, a contaminant, gas, or the like can be prevented from flowing from the second chamber into the first chamber.

In the treatment device described above, it is preferable that the second chamber is detachably connected to the second gate valve.

According to the present invention, the second chamber can be mounted and dismounted with respect to the transport unit in a state where the atmosphere of the inside of the case is cut off by blocking the communication passage between the inside of the second chamber and the inside of the case by the second gate valve. In this way, the atmosphere of the inside of the first chamber which communicates with the inside of the case can be maintained as a desired atmosphere, and therefore, it is possible to efficiently perform analysis and treatment of the sample.

In the treatment device described above, it is preferable that a plurality of the second chambers are connected to the transport device.

According to the present invention, by allowing various treatments with respect to the sample, such as cooling, heating, or vapor deposition, for example, to be performed in the respective second chambers, it becomes possible to perform various treatments on the sample in the treatment device. Therefore, a reduction in the size and a reduction in the cost of the treatment device become possible, compared to a treatment device of the related art in which devices for various treatment processes and an analysis device are independently provided with respect to a sample.

According to still another aspect of the present invention, there is provided a vacuum device including: the above-described treatment device.

According to the present invention, it is possible to provide a small and low-cost vacuum device in which the device is provided with the above-described treatment device, whereby it is possible to mutually transfer a sample between the first chamber and the second chamber provided in a single device, under a vacuum atmosphere.

Furthermore, the first chamber and the second chamber are provided in the same vacuum device, and therefore, it becomes possible to share a vacuum pump which is connected to the first chamber and the second chamber, and thus the cost of the device can be further reduced.

According to still yet another aspect of the present invention, there is provided a charged particle beam device including: the above-described vacuum device; a charged particle beam column which irradiates a sample with a charged particle beam; and a detector which detects secondary particles which are emitted from the sample due to irradiation with the charged particle beam.

According to the present invention, it is possible to provide a small and low-cost charged particle beam device in which the device is provided with the above-described vacuum device, whereby it is possible to mutually transfer a sample between the first chamber and the second chamber provided in a single device, under a vacuum atmosphere.

According to the present invention, the inside of the case is sealed by the seal member and the transport bar is made so as to be able to transition between the first state where the transport bar can transport the sample between the inside of the first chamber and the inside of the case, and the second state where the transport bar can transport the sample between the inside of the second chamber and the inside of the case. Therefore, it is possible to mutually transfer the sample between the first chamber and the second chamber under an isolated atmosphere. For this reason, it becomes possible to connect the first chamber and the second chamber in a state where the inside of the first chamber and the inside of the second chamber communicate with each other under an isolated atmosphere. Therefore, it is possible to provide a transport device in which a reduction in the size and a reduction in the cost of the entire device are possible, compared to a configuration in which a first chamber and a second chamber with an isolated internal atmosphere are disposed independently of each other.

### BRIEF DESCRIPTION OF THE DRAWINGS

FIG. 1 is a configuration diagram of a treatment device of a first embodiment.
FIG. 2 is a cross-sectional view in a plane which is orthogonal to a front-back direction at the center in the front-back direction of a section A of FIG. 1.
FIG. 3 is an explanatory diagram of an operation of the treatment device of the first embodiment and is a cross-sectional view in a plane which is orthogonal to the front-back direction at the center in the front-back direction of a section equivalent to the section A of FIG. 1.
FIG. 4 is an explanatory diagram of an operation of the treatment device of the first embodiment and is a cross-sectional view in a plane which is orthogonal to the front-back direction at the center in the front-back direction of the section equivalent to the section A of FIG. 1.
FIG. 5 is an explanatory diagram of an operation of the treatment device of the first embodiment and is a cross-sectional view in a plane which is orthogonal to the front-back direction at the center in the front-back direction of the section equivalent to the section A of FIG. 1.
FIG. 6 is an explanatory diagram of an operation of the treatment device of the first embodiment and is a cross-sectional view in a plane which is orthogonal to the front-back direction at the center in the front-back direction of the section equivalent to the section A of FIG. 1.
FIG. 7 is an explanatory diagram of an operation of the treatment device of the first embodiment and is a cross-sectional view in a plane which is orthogonal to the front-back direction at the center in the front-back direction of the section equivalent to the section A of FIG. 1.
FIG. 8 is an explanatory diagram of a treatment device of a second embodiment and is a cross-sectional view in a plane which is orthogonal to the front-back direction at the center in the front-back direction of the section equivalent to the section A of FIG. 1.

### DETAILED DESCRIPTION OF THE INVENTION

Hereinafter, embodiments of the present invention will be described based on the drawings.

### [First Embodiment]

First, a treatment device 1 and a transport unit 20 (a transport device) of a first embodiment will be described. In this embodiment, a focused ion beam device which is a type of a charged particle beam device (a vacuum device) in which analysis can be performed in a state where a biological sample such as a cell is cooled will be described to be cited as an example of the treatment device 1.

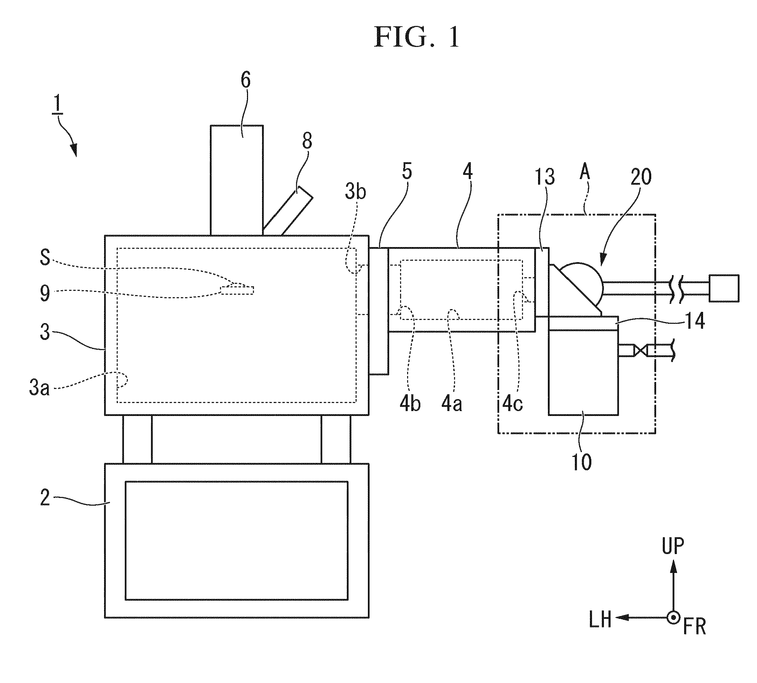

FIG. 1 is a configuration diagram of the treatment device of the first embodiment. The treatment device 1 is used in a state of being installed in a horizontal plane. In the drawing, the vertically upper side is shown by an arrow UP, the front side is shown by an arrow FR, and the left side is shown by an arrow LH.

As shown in FIG. 1, the treatment device 1 is provided with a main chamber 3 in which a sample S can be accommodated, a sub-chamber 4 (a first chamber), a first treatment chamber 10 (a second chamber), and the transport unit 20 which is interposed between the sub-chamber 4 and the first treatment chamber 10. The treatment device 1 is mounted on a vibration isolation table 2.

The main chamber 3 is formed in a hollow rectangular parallelepiped shape by using, for example, a metal material, and a sample chamber 3a is formed inside thereof. A sample stage (not shown) is disposed in the sample chamber 3a. The sample stage is made such that a sample holder 9 with the sample S fixed thereto can be set thereon. The sample holder 9 is formed of a material having a high thermal conductivity. As the material having a high thermal conductivity, for example, a metal material or the like is suitable. In the right wall of the main chamber 3, an opening 3b penetrating in a right-left direction is formed.

A first vacuum pump (not shown) is connected to the main chamber 3. The first vacuum pump depressurizes the sample chamber 3a, thereby making the sample chamber 3a be in a vacuum state. Further, an ion beam column 6 (a charged particle beam column) and a detection section 8 (a detector) are disposed at an upper portion of the main chamber 3. The ion beam column 6 is disposed so as to be able to irradiate the sample S set on the sample stage with an ion beam (a charged particle beam). The detection section 8 is provided with a secondary electron detector or the like, which detects secondary electrons (secondary particles) which are emitted from the sample S when the sample S is irradiated with the ion beam.

The sub-chamber 4 is mounted on the right side of the main chamber 3 through a gate valve 5. The sub-chamber 4 is formed in a hollow rectangular parallelepiped shape by using, for example, a metal material, and a preliminary sample chamber 4a is formed inside thereof. The spatial volume of the preliminary sample chamber 4a is made to be sufficiently small compared to the spatial volume of the sample chamber 3a. In the left wall of the sub-chamber 4, a first opening 4b penetrating in the right-left direction is formed so as to overlap the opening 3b of the main chamber 3 when viewed from the right-left direction. The first opening 4b makes the sample chamber 3a and the preliminary sample chamber 4a communicate with each other through the opening 3b of the main chamber 3 in a state where the gate valve 5 is opened. Further, in the right wall of the sub-chamber 4, a second opening 4c penetrating in the right-left direction is formed so as to overlap the first opening 4b when viewed from the right-left direction.

A second vacuum pump (not shown) is connected to the sub-chamber 4. The second vacuum pump depressurizes the preliminary sample chamber 4a, thereby making the preliminary sample chamber 4a be in a vacuum state. Further, a door (not shown) which opens the preliminary sample chamber 4a is provided at the sub-chamber 4, and thus it becomes possible to perform exchange work or the like of the sample holder 9 in the preliminary sample chamber 4a.

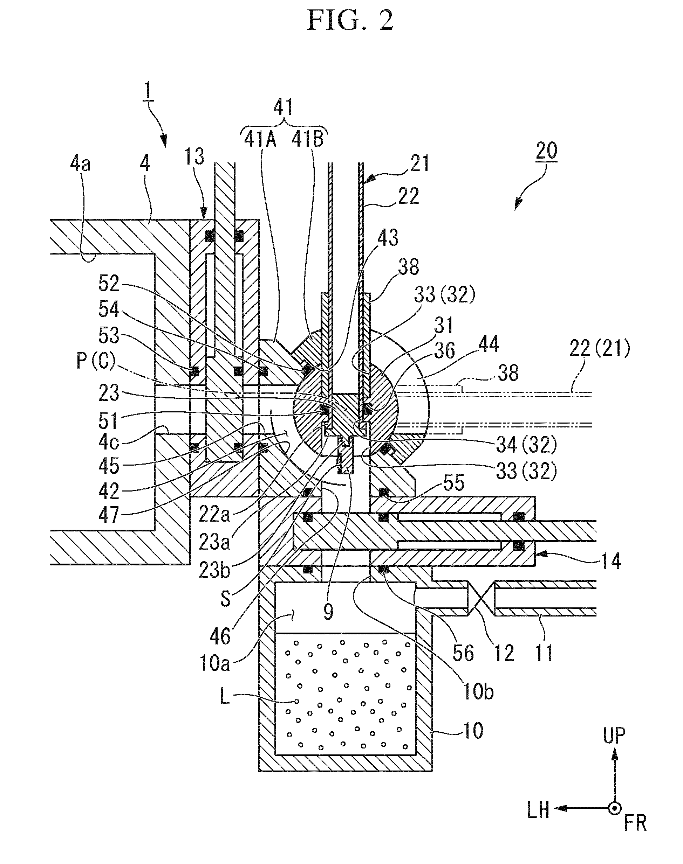

FIG. 2 is a cross-sectional view in a plane which is orthogonal to a front-back direction at the center in the front-back direction of a section A of FIG. 1.

As shown in FIG. 2, the transport unit 20 is mounted on the right side of the sub-chamber 4 through a gate valve 13 (a first gate valve). The transport unit 20 is provided with a transport bar 21 which transports the sample S, a support 31 which supports the transport bar 21, and a case 41 which supports the support 31.

The transport bar 21 transports the sample S fixed to the sample holder 9 along the right-left direction (a predetermined direction) in the inside (the preliminary sample chamber 4a) of the sub-chamber 4. The transport bar 21 is provided with a cylindrical main body section 22 and a cap 23 airtightly fitted on the inside of one end portion of the main body section 22. An outer flange portion 22a projecting radially outward from the main body section 22 is formed at one end portion of the main body section 22. The cap 23 is formed in a columnar shape. The outer diameter of the cap 23 is made to be equal to the inner diameter of the main body section 22. An outer flange portion 23a projecting radially outward from the cap 23 is formed at one end portion of the cap 23. The outer diameter of the outer flange portion 23a of the cap 23 is made to be equal to the outer diameter of the outer flange portion 22a of the main body section 22. The surface on the other end side of the outer flange portion 23a of the cap 23 is in contact with the surface on one end side of the outer flange portion 22a of the main body section 22.

A mounting portion 23b on which the sample holder 9 is mounted is provided to protrude from one end portion of the cap 23 (hereinafter, there is a case where the one end portion is referred to as a "tip portion of the transport bar 21"). The mounting portion 23b is, for example, a male screw, a hook, or the like which is coupled to the sample holder 9.

The support 31 is formed in a spherical shape by using, for example, a metal material or the like. A through-hole 32 having a circular cross-section is formed in the support 31. The central axis of the through-hole 32 passes through the center of the support 31. The through-hole 32 has a pair of large-diameter portions 33 and a small-diameter portion 34. The pair of large-diameter portions 33 is formed so as to become coaxial with each other with the small-diameter portion 34 interposed therebetween. The inner diameter of each of the pair of large-diameter portions 33 is made to be larger than the outer diameter of the outer flange portion 22a in the main body section 22 of the transport bar 21. The inner diameter of the small-diameter portion 34 is made to be equal to the outer diameter of the main body section 22 of the transport bar 21. A groove portion 36 is formed along a circumferential direction of the small-diameter portion 34 in the inner peripheral surface of the small-diameter portion 34.

A guide tube 38 is fitted on the inside of the large-diameter portion 33 on one side, out of the pair of large-diameter portions 33. The outer diameter of the guide tube 38 is made to be equal to the inner diameter of the large-diameter portion 33. The inner diameter of the guide tube 38 is made to be equal to the inner diameter of the small-diameter portion 34, that is, be equal to the outer diameter of the main body section 22 of the transport bar 21. One end edge of the guide tube 38 is in contact with a stepped surface between the large-diameter portion 33 on one side and the small-diameter portion 34 of the support 31. The other end portion of the guide tube 38 protrudes toward the outside from the support 31.

The transport bar 21 is inserted into the through-hole 32 of the support 31. Specifically, the transport bar 21 is inserted into the inside of the small-diameter portion 34 and the guide tube 38 such that the outer flange portion 22a of the main body section 22 and the outer flange portion 23a of the cap 23 are located further toward the side of the large-diameter portion 33 on the other side than the small-diameter portion 34. The outer flange portion 22a of the main body section 22 of the transport bar 21 is made so as to be able to come into contact with a stepped surface between the large-diameter portion 33 on the other side and the small-diameter portion 34 of the support 31. In this way, coming-out of the transport bar 21 from the through-hole 32 is restricted. A first O-ring 51 fitted into the groove portion 36 is interposed between the outer peripheral surface of the main body section 22 of the transport bar 21 and the inner peripheral surface of the small-diameter portion 34 of the support 31. The first O-ring 51 performs sealing between the transport bar 21 and the through-hole 32 of the support 31. A tip portion of the transport bar 21 is accommodated inside of the large-diameter portion 33 on the other side in a state where the outer flange portion 22a of the main body section 22 comes into contact with the stepped surface between the large-diameter portion 33 on the other side and the small-diameter portion 34 of the support 31 (a state shown in FIG. 2, hereinafter, the state is referred to as a "pull-out state").

The case 41 is formed in a hollow shape by using, for example, a metal material or the like. The case 41 is formed so as to be able to be divided into a first case 41A provided further toward the lower left side than a center point C of a support retaining section 43 (described later) when viewed from the front, and a second case 41B provided further toward the upper right side than the center point C.

The support retaining section 43 having a spherical shape corresponding to the outer peripheral surface of the support 31 is formed on the inside of the case 41. The support retaining section 43 is formed over the first case 41A and the second case 41B. The support 31 is retained in the support retaining section 43 so as to be rotatable around the center point C of the support retaining section 43.

A second O-ring 52 (a seal member) is interposed between the support retaining section 43 and the support 31. The second O-ring 52 is disposed along a virtual plane which passes through the center point C and is rotated by 45° in a clockwise direction from a horizontal plane when viewed from the front. The second O-ring 52 performs sealing between the support retaining section 43 and the support 31.

A first opening portion 45 and a second opening portion 46 are formed in the first case 41 A.

The first opening portion 45 penetrates a left side portion of the first case 41A in the right-left direction so as to become coaxial with an axis passing through the center point C and being along the right-left direction. The opening size of the first opening portion 45 is made to be equal to the inner diameter of the large-diameter portion 33 of the support 31.

The second opening portion 46 penetrates a lower portion of the first case 41 A in an up-down direction so as to become coaxial with an axis passing through the center point C and being along the up-down direction. The opening size of the second opening portion 46 is made to be equal to the inner diameter of the large-diameter portion 33 of the support 31.

A portion between the first opening portion 45 and the second opening portion 46 on the inside of the first case 41 A becomes an enlarged diameter portion 47 formed to be further enlarged in diameter than the support retaining section 43. A space between the enlarged diameter portion 47 of the case 41 and the support 31 makes the first opening portion 45 and the second opening portion 46 communicate with each other. In the following description, a portion which makes the first opening portion 45 and the second opening portion 46 communicate with each other on the inside of the case 41 is referred to as an "inside 42 of the case 41".

A slit 44 is formed in the second case 41B. The slit 44 is formed along a plane which passes through the center point C and is orthogonal to the front-back direction. The guide tube 38 protruding from the support 31 is disposed in the slit 44. The width of the slit 44 is made to be equal to the outer diameter of the guide tube 38. In this way, the support 31 is made to be rotatable around a rotation axis P passing through the center point C and being along the front-back direction, by moving the guide tube 38 in the slit 44. One end portion of the slit 44 is provided at a position corresponding to a state where the guide tube 38 is disposed along the right-left direction (a state shown by a two-dot chain line in FIG. 2). The other end portion of the slit 44 is provided at a position corresponding to a state where the guide tube 38 is disposed along the up-down direction (a state shown by a solid line in FIG. 2).

The case 41 is disposed with respect to the sub-chamber 4 such that the first opening portion 45 is located at a position corresponding to the second opening 4c of the sub-chamber 4 when viewed from the right-left direction. The gate valve 13 is interposed between the sub-chamber 4 and the case 41. The gate valve 13 is detachably mounted on each of the sub-chamber 4 and the case 41 by, for example, bolts or the like. In this way, the transport unit 20 is detachably connected to the gate valve 13. A third O-ring 53 is interposed between the gate valve 13 and the sub-chamber 4. Further, a fourth O-ring 54 is interposed between the gate valve 13 and the case 41.

The inside 42 of the case 41 communicates with the preliminary sample chamber 4a through the first opening portion 45 of the case 41 and the second opening 4c of the sub-chamber 4. The first opening portion 45 of the case 41 and the second opening 4c of the sub-chamber 4 form a communication passage between the inside 42 of the case 41 and the preliminary sample chamber 4a. The gate valve 13 opens and closes the communication passage between the inside 42 of the case 41 and the preliminary sample chamber 4a.

The first treatment chamber 10 is mounted on the lower side of the case 41 through a gate valve 14 (a second gate valve). The first treatment chamber 10 is formed in a hollow rectangular parallelepiped shape and is made so as to be able to store a refrigerant L such as liquid nitrogen or liquefied ethane, for example, in a first treatment space 10a inside thereof. In the first treatment chamber 10, an opening 10b penetrating an upper wall of the first treatment chamber 10 in the up-down direction is formed. The opening 10b is formed, for example, in the same shape as the second opening portion 46 of the case 41 when viewed from the up-down direction. A pipe 11 is connected to an upper portion of the first treatment chamber 10. A valve 12 switchable the through flow rate of gas in the pipe 11 is provided at a middle portion of the pipe 11. The first treatment space 10a is made so as to be able to be evacuated through the pipe 11 by, for example, the second vacuum pump (not shown). The first treatment chamber 10 is regarded as being a chamber for cooling treatment which cools the sample S by the refrigerant L.

The first treatment chamber 10 is disposed with respect to the case 41 such that the opening 10b is located at a position corresponding to the second opening portion 46 of the case 41 when viewed from the up-down direction. The gate valve 14 is interposed between the first treatment chamber 10 and the case 41. The gate valve 14 is detachably mounted on each of the case 41 and the first treatment chamber 10 by, for example, bolts or the like. In this way, the first treatment chamber 10 is detachably connected to the gate valve 14. A fifth O-ring 55 is interposed between the gate valve 14 and the case 41. Further, a sixth O-ring 56 is interposed between the gate valve 14 and the first treatment chamber 10.

The first treatment space 10a communicates with the inside 42 of the case 41 through the opening 10b of the first treatment chamber 10 and the second opening portion 46 of the case 41. The opening 10b of the first treatment chamber 10 and the second opening portion 46 of the case 41 form a communication passage between the first treatment space 10a and the inside 42 of the case 41. The gate valve 14 opens and closes the communication passage between the first treatment space 10a and the inside 42 of the case 41. The first treatment space 10a and the preliminary sample chamber 4a are made so as to be able to communicate with each other through the inside 42 of the case 41.

The inside 42 of the case 41 is sealed with respect to the outside through the slit 44, by the first O-ring 51 and the second O-ring 52. In this way, the preliminary sample chamber 4a, the inside 42 of the case 41, and the first treatment space 10a have atmosphere isolated with respect to the outside.

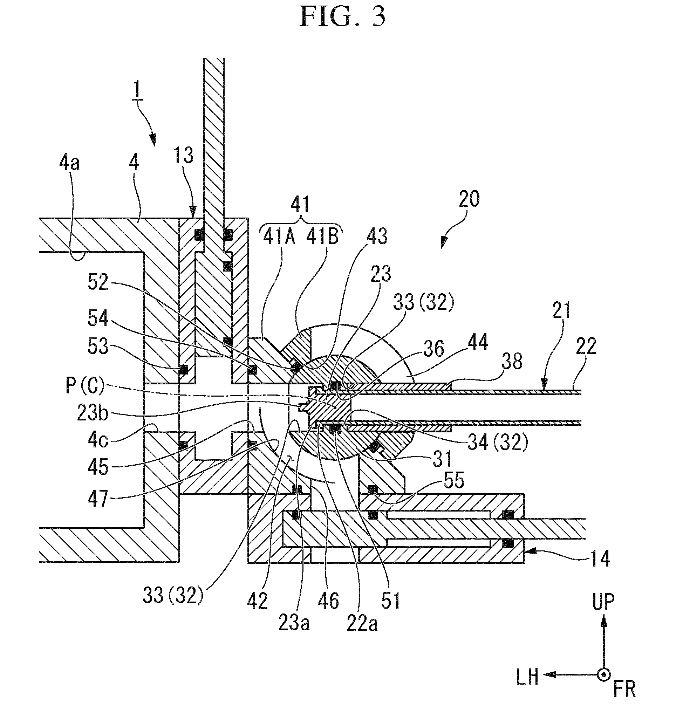

Hereinafter, operations of the treatment device 1 and the transport unit 20 of this embodiment will be described with reference to FIGS. 3 to 7. In this embodiment, procedure for observing the sample S by a focused ion beam in a state where a biological sample such as a cell is cooled will be described.

FIGS. 3 to 7 are explanatory diagrams of the operation of the treatment device of the first embodiment and are cross-sectional views in a plane which is orthogonal to the front-back direction at the center in the front-back direction of the section A of FIG. 1.

First, the sample S is set on the sample holder 9 outside of the treatment device 1. Further, in order to accommodate liquid nitrogen (the refrigerant L) in the first treatment space 10a, after the gate valve 14 is closed, the first treatment chamber 10 is removed from the gate valve 14.

Next, as shown in FIG. 3, the gate valve 13 is opened. At this time, the gate valve 5 is in a closed state, and the sample chamber 3a is evacuated by the first vacuum pump (not shown) (refer to FIG. 1). Subsequently, the guide tube 38 is made so as to be in a state of being disposed along the right-left direction. In this way, the transport bar 21 inserted into the guide tube 38 is in a state of being along the right-left direction. By displacing the transport bar 21 with respect to the support 31, the tip portion of the transport bar 21 can be moved between the preliminary sample chamber 4a and the inside 42 of the case 41 through the second opening 4c of the sub-chamber 4 and the first opening portion 45 of the case 41. Accordingly, the transport bar 21 can transport the sample S between the preliminary sample chamber 4a and the inside 42 of the case 41 by mounting the sample holder 9 on the mounting portion 23b of the tip portion thereof. A state where the transport bar 21 is made so as to be able to transport the sample S between the preliminary sample chamber 4a and the inside 42 of the case 41 is hereinafter referred to as a "first state".

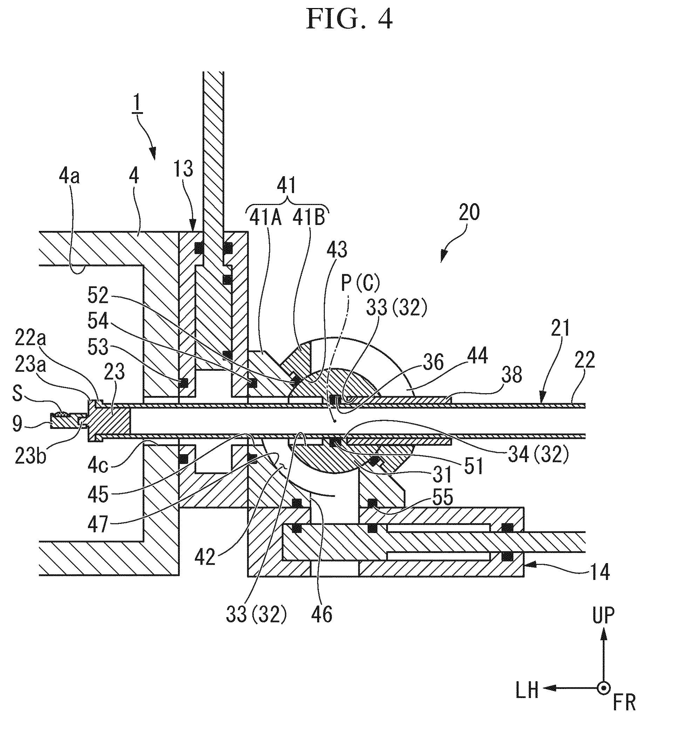

Next, as shown in FIG. 4, the pressure in the preliminary sample chamber 4a and the inside 42 of the case 41 is increased to atmospheric pressure by introducing gas such as air or nitrogen into the preliminary sample chamber 4a, and the door of the sub-chamber 4 is opened. Subsequently, the transport bar 21 is pushed toward the left side, whereby the tip portion of the transport bar 21 is moved into the preliminary sample chamber 4a. Subsequently, the sample holder 9 with the sample S fixed thereto is put in the preliminary sample chamber 4a and mounted on the mounting portion 23b of the tip portion of the transport bar 21.

Next, the door of the sub-chamber 4 is closed, and the transport bar 21 is pulled out toward the right side, whereby the pull-out state is created. Subsequently, the gate valve 13 is closed, thereby cutting off the atmosphere of the preliminary sample chamber 4a.

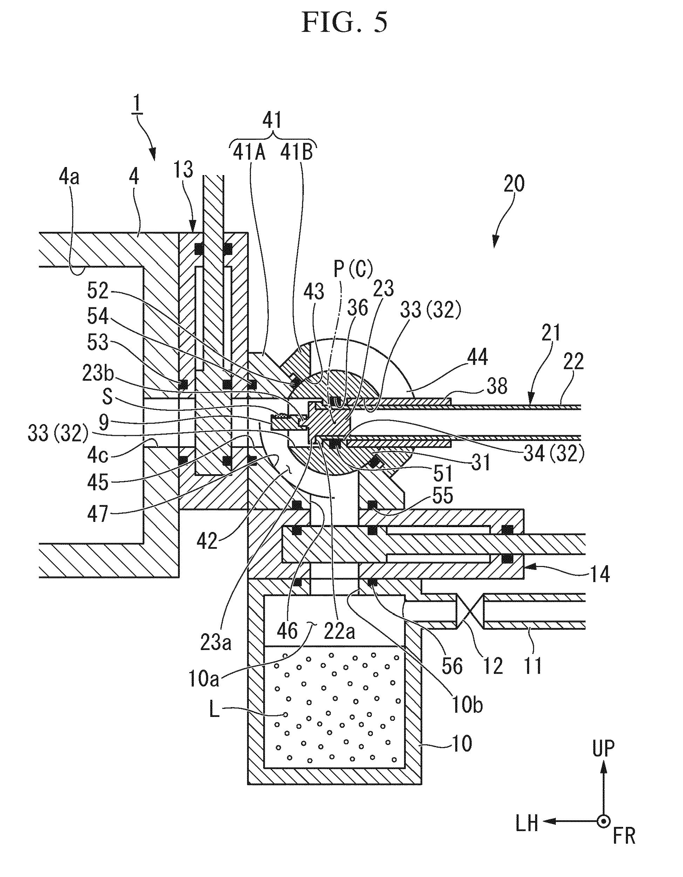

Next, as shown in FIG. 5, the first treatment chamber 10 with liquid nitrogen (the refrigerant L) accommodated therein is mounted on the gate valve 14. Subsequently, the valve 12 is opened, and the first treatment space 10a is evacuated by the second vacuum pump (not shown). In this way, the liquid nitrogen accommodated in the first treatment chamber 10 becomes slush nitrogen in which particulate solid nitrogen is dispersed. The temperature of the liquid nitrogen is about -196°C, whereas the temperature of the slush nitrogen is lowered to about -210°C.

Next, the transport bar 21 along with the guide tube 38 is rotated by 90° in a counterclockwise direction around the rotation axis P when viewed from the front, whereby a state where the guide tube 38 is disposed along the up-down direction is created. In this way, the transport bar 21 is made so as to be able to transport the sample S disposed at the tip portion thereof between the first treatment space 10a and the inside 42 of the case 41. A state where the transport bar 21 is made so as to be able to transport the sample S between the first treatment space 10a and the inside 42 of the case 41 is hereinafter referred to as a "second state".

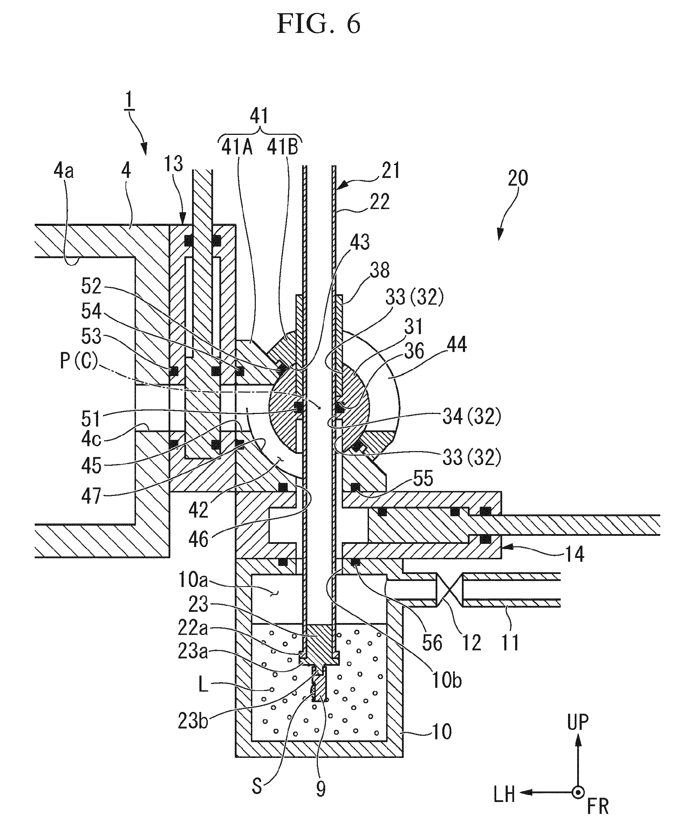

Next, as shown in FIG. 6, the gate valve 14 is opened, and the transport bar 21 is pushed downward, whereby the tip portion of the transport bar 21 is moved to the first treatment space 10a. In this way, the sample S disposed at the tip portion of the transport bar 21 is immersed in the slush nitrogen. Here, even if the sample S having a higher temperature than the slush nitrogen and the sample holder 9 are immersed in the slush nitrogen, the slush nitrogen does not boil immediately, unlike liquid nitrogen, and therefore, the slush nitrogen is suitable as a refrigerant.

Next, the pull-out state is created by pulling out the transport bar 21 toward the upper side. Subsequently, the gate valve 14 is closed. Further, the preliminary sample chamber 4a is evacuated by the second vacuum pump. If the degree of vacuum of the preliminary sample chamber 4a reaches a predetermined degree of vacuum, the gate valve 5 and the gate valve 13 are opened.

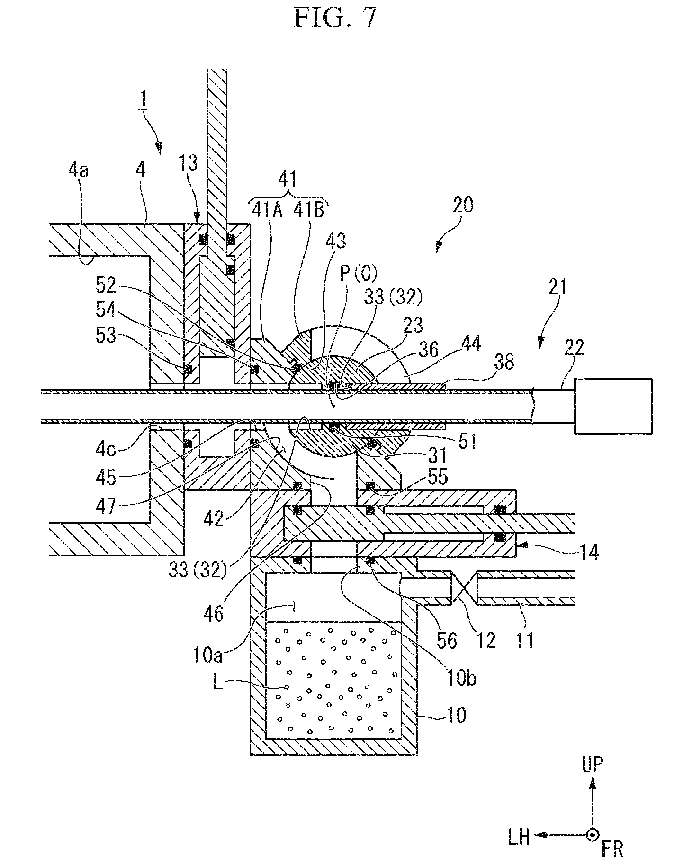

Next, as shown in FIG. 7, the transport bar 21 is rotated by 90° in the clockwise direction around the rotation axis P when viewed from the front, whereby the first state is created. In this way, the transport bar 21 is made so as to be able to transport the sample S disposed at the tip portion thereof between the sample chamber 3a (refer to FIG. 1) and the inside of the case 41 through the preliminary sample chamber 4a. Subsequently, the transport bar 21 is pushed toward the left side, whereby the tip portion of the transport bar 21 is moved to the sample chamber 3a, and the sample holder 9 mounted on the tip portion is set on the sample stage (not shown). Thereafter, analysis of the sample S is performed by the ion beam column 6 and the detection section 8 shown in FIG. 1.

In this way, it is possible to transport the sample subjected to cooling treatment in the first treatment chamber 10, to the sample chamber 3a without bringing into direct contact with the air.

In this manner, according to this embodiment, the inside 42 of the case 41 is sealed by the second O-ring 52 and the transport bar 21 is made so as to be able to transition between the first state where the transport bar 21 can transport the sample S between the preliminary sample chamber 4a and the inside 42 of the case 41, and the second state where the transport bar 21 can transport the sample S between the first treatment space 10a and the inside 42 of the case 41. Therefore, it is possible to mutually transfer the sample S between the sub-chamber 4 and the first treatment chamber 10 provided in the treatment device 1, under an isolated atmosphere. For this reason, it becomes possible to connect the sub-chamber 4 and the first treatment chamber 10 in a state where the preliminary sample chamber 4a and the first treatment space 10a communicate with each other under an isolated atmosphere. Therefore, it is possible to provide the transport unit 20 in which a reduction in the size and a reduction in the cost of the entire device are possible, compared to a configuration in which a sub-chamber 4 with an isolated internal atmosphere and a first treatment chamber 10 are disposed independently of each other.

Further, it is possible to transfer the sample S subjected to cooling treatment in the first treatment chamber 10 to the sub-chamber 4 in the treatment device 1 by the transport bar 21 of the transport unit 20. Therefore, it is possible to attain a reduction in the size and a reduction in the cost of the treatment device 1, compared to a treatment device of the related art in which a device for a cooling treatment process and an analysis device are independently provided.

Further, the gate valve 13 which opens and closes the communication passage (the second opening 4c and the first opening portion 45) between the preliminary sample chamber 4a and the inside 42 of the case 41 is provided. For this reason, communication between the preliminary sample chamber 4a and the first treatment space 10a can be cut off by blocking the communication passage between the preliminary sample chamber 4a and the inside 42 of the case 41 by the gate valve 13. In this way, in a case where the first treatment chamber 10 can become a contamination source with respect to the sub-chamber 4, a case where gas is generated from the first treatment chamber 10, or the like, a contaminant, gas, or the like can be prevented from flowing from the first treatment chamber 10 into the sub-chamber 4.

Further, the transport unit 20 is detachably connected to the gate valve 13, and therefore, the transport unit 20 along with the first treatment chamber 10 can be mounted and dismounted with respect to the sub-chamber 4 in a state where the atmosphere of the preliminary sample chamber 4a is cut off by blocking the communication passage between the preliminary sample chamber 4a and the inside 42 of the case 41 by the gate valve 13. In this way, the atmosphere of the preliminary sample chamber 4a can be maintained as a desired atmosphere, and therefore, it is possible to efficiently perform analysis and treatment of the sample S.

Further, the gate valve 14 which opens and closes the communication passage (the opening 10b and the second opening portion 46) between the first treatment space 10a and the inside 42 of the case 41 is provided. For this reason, communication between the preliminary sample chamber 4a and the first treatment space 10a can be cut off by blocking the communication passage between the preliminary sample chamber 4a and the inside 42 of the case 41 by the gate valve 14. In this way, in a case where the first treatment chamber 10 can become a contamination source with respect to the sub-chamber 4, a case where gas is generated from the first treatment chamber 10, or the like, a contaminant, gas, or the like can be prevented from flowing from the first treatment chamber 10 into the sub-chamber 4.

Further, the first treatment chamber 10 is detachably connected to the gate valve 14, and therefore, the first treatment chamber 10 can be mounted and dismounted with respect to the transport unit 20 in a state where the atmosphere of the inside 42 of the case 41 is cut off. In this way, the atmosphere of the preliminary sample chamber 4a communicating with the inside 42 of the case 41 can be maintained as a desired atmosphere, and therefore, it is possible to efficiently perform analysis and treatment of the sample.

Further, the treatment device 1 can be made to be a small and low-cost vacuum device in which it is possible to mutually transfer the sample S between the sub-chamber 4 and the first treatment chamber 10 provided in a single device, under a vacuum atmosphere.

Furthermore, the sub-chamber 4 and the first treatment chamber 10 are provided in the same treatment device 1, and therefore, it becomes possible to share the second vacuum pump which is connected to the sub-chamber 4 and the first treatment chamber 10, and thus the cost of the device can be further reduced.

Further, the treatment device 1 can be made to be a small and low-cost charged particle beam device in which it is possible to mutually transfer the sample S between the sub-chamber 4 and the first treatment chamber 10 provided in a single device, under a vacuum atmosphere.

### [Second Embodiment]

Next, a treatment device 101 and a transport unit 120 (a transport device) of a second embodiment will be described.

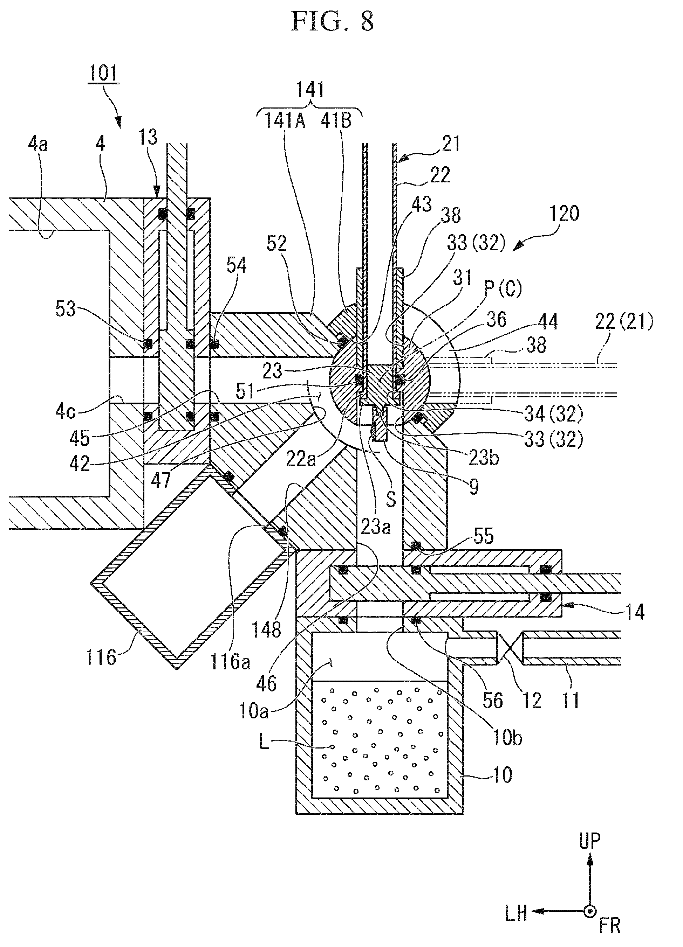

FIG. 8 is an explanatory diagram of the treatment device of the second embodiment and is a cross-sectional view in a plane which is orthogonal to the front-back direction at the center in the front-back direction of a section equivalent to the section A of FIG. 1.

In the first embodiment shown in FIG. 2, the first treatment chamber 10 is mounted on the case 41. In contrast, in the second embodiment shown in FIG. 8, the first treatment chamber 10 and a second treatment chamber 116 (a second chamber) are mounted on a case 141, and in this regard, the second embodiment is different from the first embodiment. The same configurations as those in the first embodiment shown in FIG. 2 are denoted by the same reference numerals, and the detailed description thereof is omitted.

As shown in FIG. 8, the case 141 of the transport unit 120 is formed so as to be able to be divided into a first case 141A provided further toward the lower left side than the center point C when viewed from the front, and the second case 41B provided further toward the upper right side than the center point C.

The first opening portion 45, the second opening portion 46, and a third opening portion 148 are formed in the first case 141 A. The third opening portion 148 penetrates a lower left portion of the first case 141A so as to become coaxial with an axis passing through the center point C and being along a direction inclined by 45° with respect to the right-left direction and the up-down direction. The opening size of the third opening portion 148 is made to be equal to the inner diameter of the large-diameter portion 33 in the through-hole 32 of the support 31.

The second treatment chamber 116 is mounted on the lower left side of the case 141. The second treatment chamber 116 is formed in a hollow rectangular parallelepiped shape and provided with an opening 116a penetrating an upper wall thereof. The second treatment chamber 116 is detachably mounted on the case 141 such that the opening 116a is located at a position corresponding to the third opening portion 148 of the case 141. The second treatment chamber 116 is regarded as being, for example, a chamber for heating treatment with a sheathed heater or the like provided inside thereof.

In this manner, in the treatment device 101 of this embodiment, the first treatment chamber 10 and the second treatment chamber 116 are connected to the transport unit 120. For this reason, in the treatment device 101, it becomes possible to perform cooling and heating treatment on the sample S in the respective treatment chambers 10 and 116. Therefore, it becomes possible to attain a reduction in the size and a reduction in the cost of the treatment device 101, compared to a treatment device of the related art in which devices for various treatment processes and an analysis device with respect to the sample S are independently provided.

In the second embodiment described above, the second treatment chamber 116 for heating treatment is connected to the case 141. However, there is no limitation thereto, and the second treatment chamber 116 may be, for example, a chamber for steam treatment, sputtering treatment, or the like.

Further, a gate valve may be interposed between the second treatment chamber 116 and the case 141.

Further, in the second embodiment described above, two treatment chambers (sub-chambers) are connected to the transport unit 120. However, there is no limitation thereto, and three or more treatment chambers (sub-chambers) may be connected thereto.

The present invention is not limited to the above-mentioned embodiments described with reference to the drawings, and various modification examples are conceivable within the technical scope thereof.

For example, in each embodiment described above, the support 31 is formed in a spherical shape. However, there is no limitation thereto, and the support 31 may be formed in a prolate spheroid shape, for example.

Further, in each embodiment described above, the second vacuum pump connected to the sub-chamber 4 is connected to and shared by the first treatment chamber 10. However, there is no limitation thereto, and an independent vacuum pump may be connected to the first treatment chamber 10.

Further, in each embodiment described above, the transport bar 21 is made so as to be rotatable around the rotation axis P orthogonal to the right-left direction. However, there is no limitation thereto, and the transport bar 21 may be made so as to be rotatable around a rotation axis intersecting the right-left direction.

Further, in each embodiment described above, the first treatment chamber 10 for cooling treatment is connected to the case 41 or 141. However, there is no limitation thereto, and the first treatment chamber 10 may be, for example, a chamber for heating treatment, steam treatment, sputtering treatment, or the like.

Further, in each embodiment described above, the focused ion beam device has been described to be cited as an example of the charged particle beam device. However, there is no limitation thereto, and a scanning electron microscope, or the like is also acceptable. Further, as the vacuum device, it is not limited to the charged particle beam device, and for example, an analysis device such as Auger electron spectroscopy or secondary ion mass spectrometry, a scanning probe microscope, or the like is also acceptable.

Further, in each embodiment described above, the biological sample has been described to be cited as an example of the sample S. However, there is no limitation thereto, and the sample may be, for example, a semiconductor sample, or the like.

In addition, it is appropriately possible to replace the constituent elements in the above-described embodiments with well-known constituent elements within a scope which does not depart from the gist of the present invention.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

### EXPLANATION OF REFERENCES

- 1:: treatment device (vacuum device or charged particle beam device)
- 3:: main chamber
- 4:: sub-chamber (first chamber)
- 4a:: preliminary sample chamber (the inside of first chamber)
- 6:: ion beam column (charged particle beam column)
- 8:: detection section (detector)
- 10:: first treatment chamber (second chamber)
- 10a:: first treatment space (the inside of second chamber)
- 13:: gate valve (first gate valve)
- 14:: gate valve (second gate valve)
- 20, 120:: transport unit (transport device)
- 21:: transport bar
- 31:: support
- 41, 141:: case
- 42:: inside of case
- 52:: second O-ring (seal member)
- 116:: second treatment chamber (second chamber)
- P:: rotation axis
- S:: sample

## Claims

1. A transport device which is interposed between a first chamber and a second chamber, comprising:
a transport bar which transports a sample along a predetermined direction in the first chamber;
a support which supports the transport bar;
a case which supports the support so as to be rotatable around a rotation axis intersecting the predetermined direction; and
a seal member which is disposed between the support and the case and seals the inside of the case,
wherein the inside of the first chamber and the inside of the second chamber can communicate with each other through the inside of the case, and
the transport bar is made so as to be able to transition between a first state where the transport bar can transport the sample between the inside of the first chamber and the inside of the case, and a second state where the transport bar can transport the sample between the inside of the second chamber and the inside of the case, by rotation of the support with respect to the case.

2. A treatment device comprising:
the transport device according to Claim 1;
the first chamber; and
the second chamber.

3. The treatment device according to Claim 2, further comprising:
a first gate valve which is interposed between the first chamber and the case and opens and closes a communication passage between the inside of the first chamber and the inside of the case.

4. The treatment device according to Claim 3, wherein the transport device is detachably connected to the first gate valve.

5. The treatment device according to any one of Claims 2 to 4, further comprising:
a second gate valve which is interposed between the second chamber and the case and opens and closes a communication passage between the inside of the second chamber and the inside of the case.

6. The treatment device according to Claim 5, wherein the second chamber is detachably connected to the second gate valve.

7. The treatment device according to any one of Claims 2 to 6, wherein a plurality of the second chambers are connected to the transport device.

8. A vacuum device comprising:
the treatment device according to any one of Claims 2 to 7.

9. A charged particle beam device comprising:
the vacuum device according to Claim 8;
a charged particle beam column which irradiates a sample with a charged particle beam; and
a detector which detects secondary particles which are emitted from the sample due to irradiation with the charged particle beam.
